(19) Europäisches Patentamt
European Patent Office
Office européen des brevets

(11) **EP 4 370 939 B1**

(12) **EUROPEAN PATENT SPECIFICATION**

(45) Date of publication and mention
of the grant of the patent:
**06.05.2026 Bulletin 2026/19**

(21) Application number: **21740547.1**

(22) Date of filing: **12.07.2021**

(51) International Patent Classification (IPC):
**G01R 19/25** *(2006.01)*

(52) Cooperative Patent Classification (CPC):
**G01R 19/2513**

(86) International application number:
**PCT/EP2021/069264**

(87) International publication number:
**WO 2023/284934 (19.01.2023 Gazette 2023/03)**

(54) **ELECTRICAL SIGNAL ANALYSIS AND APPLIANCE MONITORING**

ANALYSE ELEKTRISCHER SIGNALE UND GERÄTEÜBERWACHUNG

ANALYSE DE SIGNAL ÉLECTRIQUE ET SURVEILLANCE D'APPAREIL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.05.2024 Bulletin 2024/21**

(73) Proprietor: **Eaton Intelligent Power Limited Dublin 4 (IE)**

(72) Inventor: **CAHILL, Niall Dublin 15 Dublin (IE)**

(74) Representative: **Jolliffe, Jack Louis Venner Shipley LLP 200 Aldersgate London EC1A 4HD (GB)**

(56) References cited:
WO-A1-2016/079229    US-A1- 2014 320 125
US-A1- 2020 292 608    US-A1- 2021 088 563

- WEN HE ET AL: "Frequency Estimation of Distorted and Noisy Signals in Power Systems by FFT-Based Approach", IEEE TRANSACTIONS ON POWER SYSTEMS, IEEE, USA, vol. 29, no. 2, 1 March 2014 (2014-03-01), pages 765 - 774, XP011540067, ISSN: 0885-8950, [retrieved on 20140214], DOI: 10.1109/TPWRS.2013.2283273
- JALEN STREMFELJ ET AL: "Nonparametric Estimation of Power Quantities in the Frequency Domain Using Rife-Vincent Windows", IEEE TRANSACTIONS ON INSTRUMENTATION AND MEASUREMENT, IEEE, USA, vol. 62, no. 8, 1 August 2013 (2013-08-01), pages 2171 - 2184, XP011519141, ISSN: 0018-9456, DOI: 10.1109/TIM.2013.2267433

## Description

TECHNICAL FIELD

The disclosure relates to methods and apparatus for electrical signal analysis and appliance monitoring.

BACKGROUND

For an electrical load such as a complex appliance, a detected electrical signal relating to that electrical load - such as the current to the load or the voltage across it with respect to time as power is switched on - will itself have a complicated form. This form will be representative of internal state changes within the complex appliance or other electrical load.

- Prior art document US2020/0292608A1 performs state detection for electrical loads in power networks, involving building a waveform model from measured electrical signals associated with the load and using the residual difference between the model output and the signals themselves to identify load states and -state transitions.

It would be desirable to use the form of such electrical signals to represent and analyse changes in internal state within such loads. A technique that proved effective to do this would have numerous uses, for example in appliance monitoring - a change in the form of the electrical signal may be used to determine whether a component within the complex appliance was failing, or if it was working outside its normal range of operation.

SUMMARY OF DISCLOSURE

In a first aspect, the disclosure provides a method of detecting states of an electrical load from an electrical signal, comprising: providing a mathematical model for the electrical signal; using a sliding window to estimate parameters of the model, wherein a plurality of windows are determined for the electrical signal, a window function is applied for each of the windows, and parameters of the model are determined by interpolation; reconstructing the waveform from the determined parameters and subtracting the reconstructed waveform from the original signal to obtain a residual signal; determining a state transition where the residual signal exceeds a threshold; and detecting a state as existing for the time period between successive state transitions.

Using this approach, the electrical signal can be broken down logically and repeatedly into a sequence of states. Variation in this sequence of states - for example, absence of a particular state, or a variation in the time taken for specific states to appear or finish - can be used to monitor an electrical device or an electrical system for changes, and may even be used for fault diagnosis, particularly if specific states can be identified with specific real world states or criteria.

This mathematical model may be a sinusoidal model comprising a fundamental frequency and harmonics of the fundamental frequency. This is a particularly suitable approach to take in respect of an AC electrical signal.

In embodiments, the window function is a Rife-Vincent window function - this choice of window function is found to be particularly appropriate to this approach to analysis of the electrical signal. This may be a Class 1 Rife-Vincent Window function, and this Class 1 Rife-Vincent Window function is of order 6 or greater.

In embodiments, wherein the residual signal exceeding a threshold may involve determining whether the root mean square value of the residual signal exceeds the threshold value.

In embodiments, the method may further comprise sampling the electrical signal into a buffer, and applying the sliding window to the buffer. The buffer may then be emptied when a state transition is detected.

In a second aspect, the disclosure provides a method of monitoring an electrical system, comprising: detecting states of an electrical load from an electrical signal according to the method of the first aspect above; and comparing the states of the electrical load with expected states of the electrical load.

In embodiments, comparing the states of the electrical load with expected states of the electrical load may comprise determining the presence or absence of states of the electrical load. Comparing the states of the electrical load with expected states of the electrical load may also comprise determining times at which one or more states of the electrical load are present.

In embodiments, this method may further comprise determination of a fault in the electrical system from comparing the states of the electrical load with expected states of the electrical load.

In a third aspect, the disclosure provides an electrical device comprising a detection element for detecting values of an electrical signal passing through the electrical device, wherein the detection element is adapted for carrying out the method of either the first or the second aspect above.

Such an electrical device may be an electrical appliance, and wherein detected states are states of the electrical appliance. Alternatively, the electrical device may be a circuit breaker.

BRIEF DESCRIPTION OF FIGURES

Embodiments of the disclosure will now be described, by way of example, with reference to the following figures, in which:

Figure 1 shows an exemplary system in which electrical signal analysis and appliance monitoring according to an embodiment of the disclosure may be carried out;

Figure 2 is an AC current waveform relating to a complex appliance - in this case, a circuit breaker supplying a furnace - considered in a worked embodiment of the disclosure;

Figure 3 shows a method of electrical signal analysis and appliance monitoring according to a broad embodiment of the disclosure;

Figure 4 shows in detail a specific embodiment of an electrical signal analysis method according to the disclosure;

Figure 5 shows a time series of parameters of a waveform model estimated for the waveform of Figure 2;

Figure 6 shows a reconstruction of the waveform of Figure 2 using the parameters of Figure 5; and

Figure 7 shows a segmentation of the electrical signal into a series of identified segments with transitions between them.

DETAILED DESCRIPTION

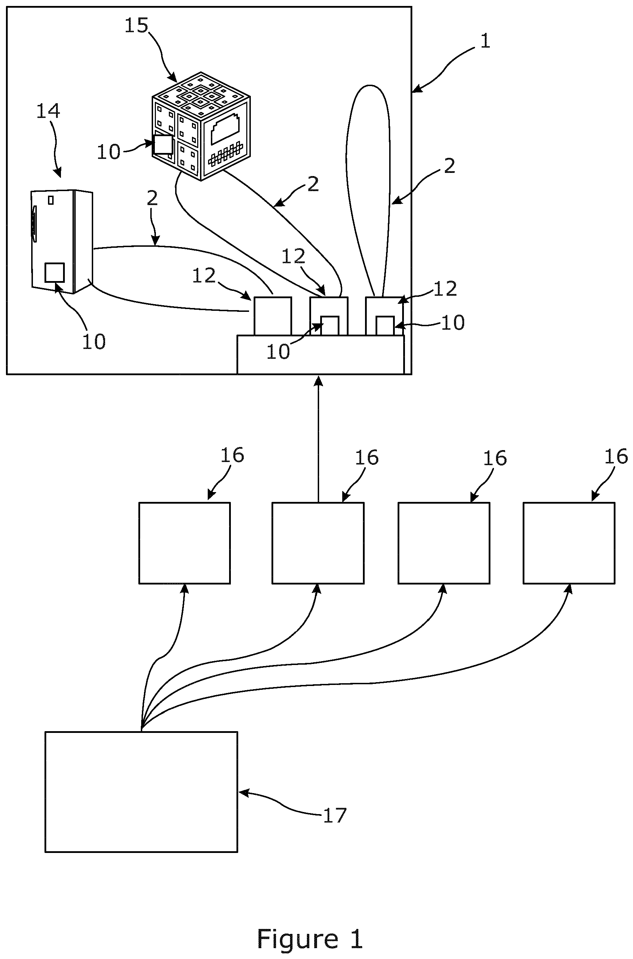

As indicated above, it would be desirable to use a detected electrical signal relating to an electrical load to analyse internal state changes relating to the load. Figure 1 shows an electrical distribution system to illustrate a number of points where such detection and analysis could take place.

Building 1 has a plurality of electrical circuits 2 powered from an electrical supply 3. These electrical circuits 2 will typically contain control elements such as circuit breakers 12 - such circuit breakers would be a particularly logical point to contain a detection element 10. This is not the only possible point in the system where this approach could be used, however - it could be employed elsewhere, or in multiple locations through the building 1 or in the wider electrical system containing the building. Individual loads within the building may have their own detection element 10 - for example appliances such as refrigeration unit 14 or furnace 15 may have their own detection element 10. These detection elements 10 may be used particularly for detection and analysis at the turning on of a load - particularly the turning on of a motor, or a set of motors. Such detection may be used in a local substation 16 supplying electrical power to a group of buildings, or even in a larger substation 17 supplying a plurality of local substations 16.

In embodiments, detection and analysis may both take place within the detecting element - for example, within a "smart" circuit breaker 12 - or the analysis may take place within a computing system connected to the detection element 10 (such as a home computing hub 13) or remotely (for example, through a cloud service).

The general approach employed in embodiments of the disclosure involves automated segmentation of the electrical signal detected by a detection element. Typically, the input to be assessed from the detection element is a digitally acquired time-series representation of an alternating current and voltage source. The output of the segmentation process may then be a set of segments extracted from the time-series corresponding to data acquired during the different states of a connected load. This is achieved by analyzing the residual signal produced by a model of the electrical signal for abrupt changes or state transitions.

The data between transitions are considered as discrete segments (referred to below as "segments" or "data segments". The benefit of this electrical signal segmentation approach is that the data segments correspond to individual states of a load such as a complex appliance, enabling these individual states to be individually analyzed and tracked. This enables more fine-individually condition monitoring of a complex appliance or a system of loads.

Segmentation is a known data analysis approach, used for images in particular but also for other types of signal. Segmentation algorithms aim to simplify the analysis of signals or images by partitioning an image or signal into regions, which can then be analyzed separately. It is desirable that the resulting partition of an image/signal be meaningful, in the sense that each such partition captures data that shares some characteristic or encompasses some important feature (this may be an object in the case of images, or an event in the case of time-series).

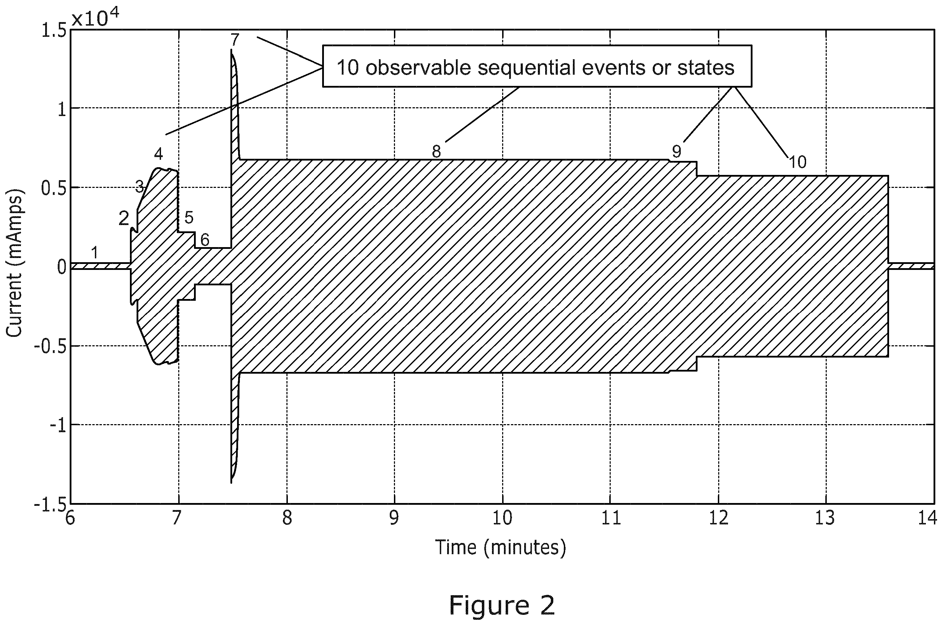

Here, the intention is to partition an AC electrical signal into segments corresponding to the various states of the load(s) drawing power on the circuit under observation. States are defined as the portion of waveform data between two adjacent abrupt changes in the electrical signal. Figure 2 illustrates how such a segmentation may look for a particular load under a particular transition (in this case, the turning on of a furnace) - in this case, 10 separate segments are shown. Such changes are commonly found in electrical signals and typically correspond to specific events of this nature. The Figure 2 example will be discussed in more detail below in the context of embodiments of the disclosure.

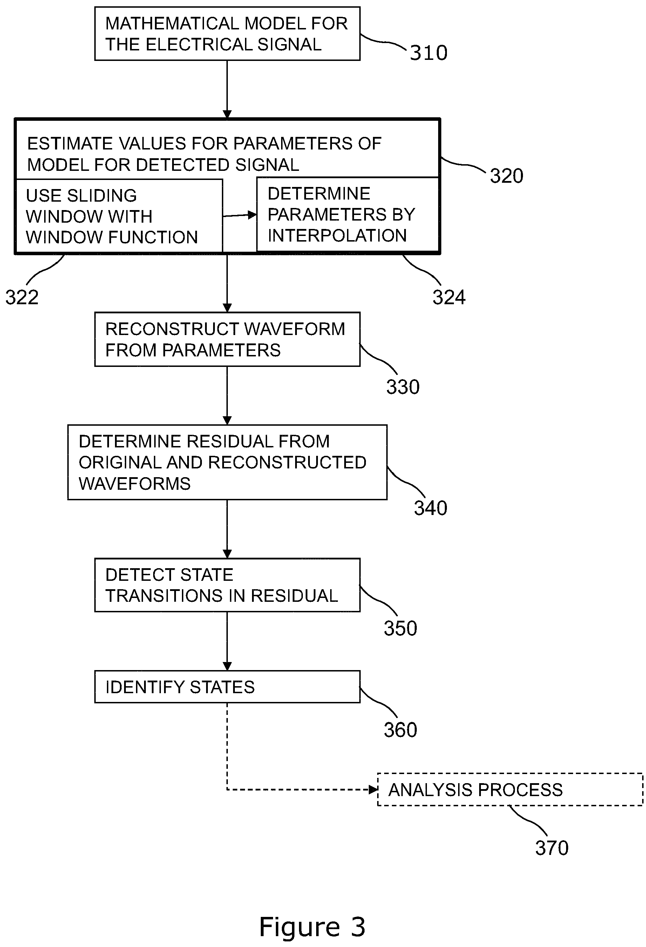

Figure 3 shows a method of electrical signal analysis and appliance monitoring according to a broad embodiment of the disclosure. The method operates by detecting states of an electrical load from an electrical signal - as indicated above, the electrical load may be from an electrical appliance, or from another load, such as a composite system comprising a collection of loads. The intention is to identify states of operation of the load which are physically meaningful.

First of all, a mathematical model for the electrical signal is provided 310. In the case of an AC waveform, this will typically be a sinusoidal model involving a fundamental frequency and a plurality of harmonics.

A sinusoidal model for use with an AC waveform can be formulated mathematically as follows,

$$i(n) = \sum_{j=1}^{j=0} c_j \sin(2\pi n f_j / f_s + \theta_j),$$

where $i$ is the current signal, $n$ is the sample index, $J$ is the number of harmonics (including the fundamental), $j$ is the index for J, and $c_j$, $f_j$ and $\theta_j$ correspond to the amplitude, frequency and phase of the $J^{th}$ harmonic (including the fundamental); these are the parameters of the model.

The next step is to estimate 320 values for the parameters of the model from the detected electrical signal. This can be achieved by using a sliding window across the detected signal data - a window function is applied 322 to the window, and parameters of the model are determined by interpolation 324.

The parameters of the model may for example be estimated online in a sliding windowed manner using an Interpolated Windowed Fast Fourier Transform (IWFFT), which applies a Rife-Vincent window function to each window of data to reduce leakage of spectral components in the frequency domain, and which then identifies peaks in the frequency domain and interpolates between these peaks using derived expressions. Practical application of this approach is described in more detail below.

After this, the waveform is reconstructed 330 from the determined parameters. The difference between a reconstruction of the signal via the model and the original signal, known as the residual, can be subjected to a threshold to detect events in the signal - this approach can be used here to detect state transition events. The reconstructed waveform is subtracted from the original signal to obtain 340 a residual signal. From this residual signal, state transitions are detected 350 - a state transition is identified when the residual signal exceeds a threshold value. States are then identified 360 as existing between successive state transitions. These states can then be used in a separate analysis process 370.

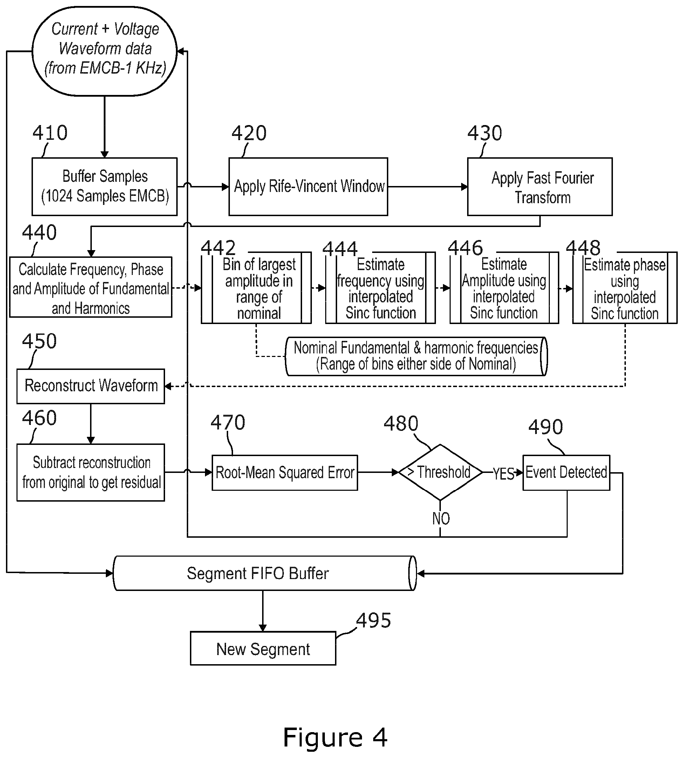

Figure 4 shows in detail a specific embodiment of an electrical signal analysis method according to the disclosure. In the case illustrated in Figure 2, the electrical signal - which may be a current or a voltage waveform - is sampled at a circuit breaker associated with a circuit supplying a furnace. While a circuit breaker is one logical location for such a detection element, a detection element may be in another electrical component, or in an appliance itself. The state detection method described below may be performed in an electrical component with an appropriate processor and firmware, or readings from the detection element may be transmitted to an appropriately configured computing apparatus either locally or remotely.

The electrical signal is sampled regularly at the detection element, and samples are buffered 410 up to a predetermined window size. A FIFO buffer is used, and as will be described below the same buffer is used for a whole segment of signal, representing a state. In the example shown here, sampling is carried out at 1 kHz and 1024 samples are used, giving a window size of approximately a second.

A window function is then applied 420 to the buffered data to prevent leakage - a generalized cosine window can be used here. These have the following form:

$$w[n] = \sum_{k=0}^{K} (-1)^k a_k \cos\left(\frac{2\pi k n}{N}\right), 0 \le n \le N$$

A particularly effective choice is found to be the use of a Rife-Vincent window - these minimize the high-order sidelobe amplitude - at order 1 (k=1), this is functionally equivalent to the widely used Hann window - here a higher order window (order 6 in the embodiment considered here) is used.

A Fast Fourier Transform (FFT) is then applied 430 to the resulting window of data to obtain a complex spectrum of the data. From this spectrum, there are calculated 440 frequency, amplitude and phase of the fundamental frequency, and also of all harmonics up to the Nyquist frequency (half of the sampling rate) - interpolation is used between the harmonics if these contain significant energy. Specifically, the bins with the largest amplitude and second largest amplitude in the region around the fundamental frequency are found 442 - this is repeated for all harmonics. Frequency is then estimated 444 (window-by-window) using an appropriate interpolation expression derived for frequency for the specified window function (in this case, for a Class I, Order 6, Rife-Vincent window). Suitable expressions can be found in Jalen Štremfelj and Dusan Agrez, "Nonparametric Estimation of Power Quantities in the Frequency Domain Using Rife-Vincent Windows", IEEE Transactions on Instrumentation and Measurement 62(8):2171-2184, August 2013. The same approach is then taken to estimating amplitude 446 and to estimating phase 448.

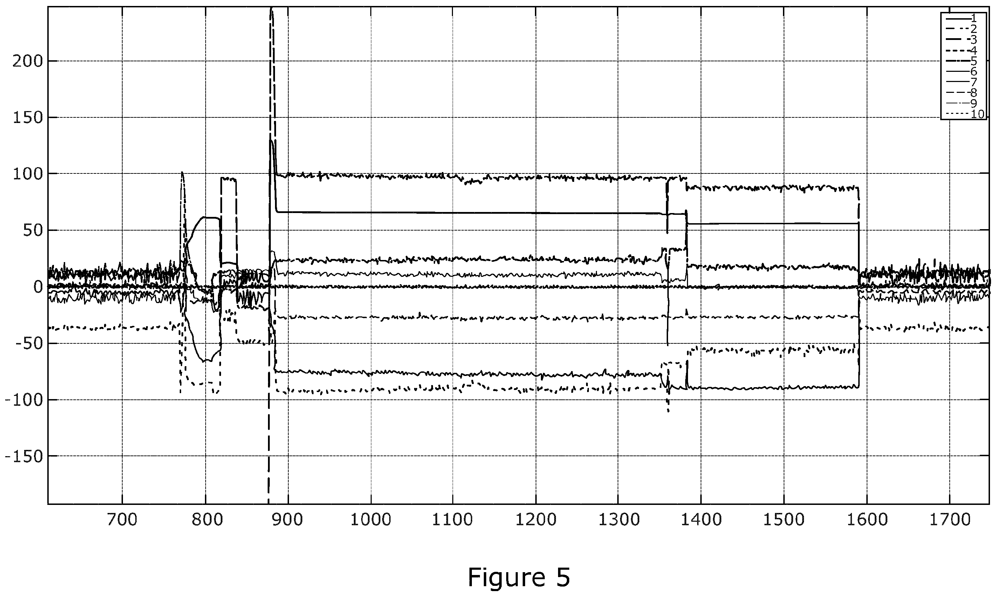

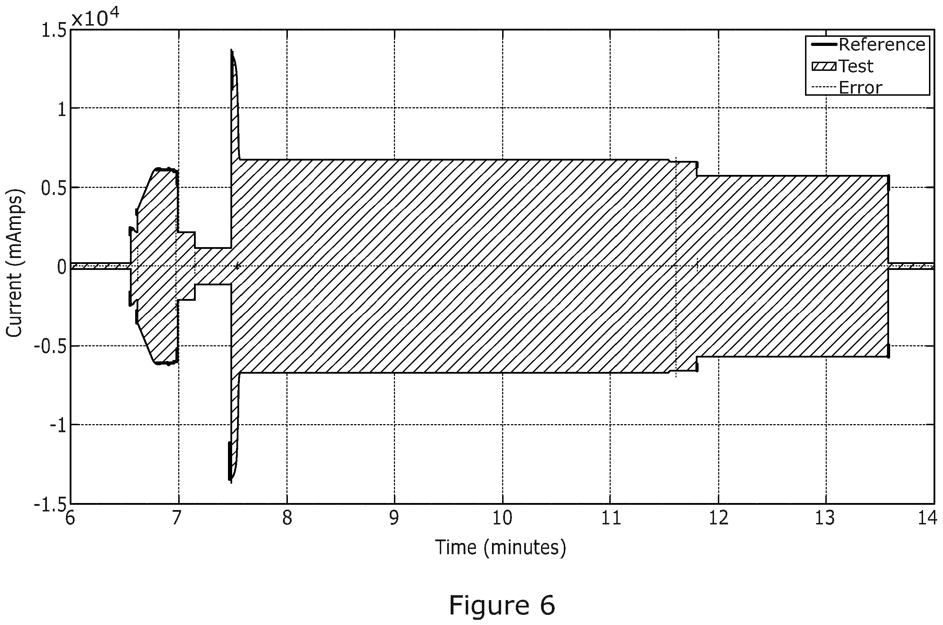

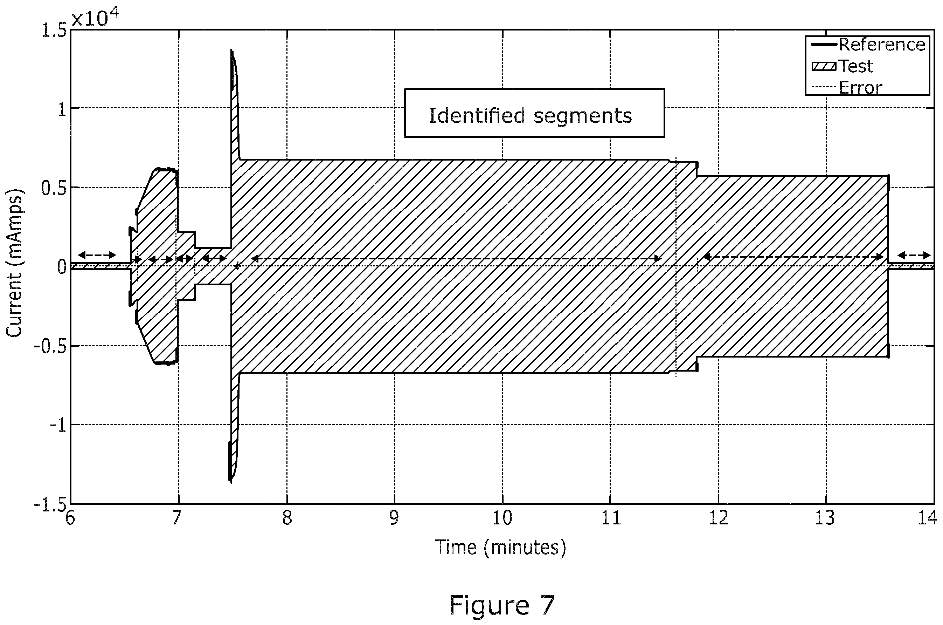

In this way, a set of estimated parameters for the waveform are built up. The waveform can then be reconstructed 450 according to the sinusoidal model indicated above with these estimated parameters. The reconstructed signal can then be subtracted 460 from the original window of waveform data - this produces a residual signal for the window. This residual signal is used to determine whether there is an event - particularly an event representing a state transition - during the window. If there is no event, the model should provide an accurate representation and the residual signal will be very low, but if there is an event, the model will no longer be accurate and the residual signal will be significantly larger. Consequently, a root-mean-squared value is determined 470 for the residual signal for the window, and this is compared 480 with a predetermined threshold value. If the threshold value is exceeded, indicating significant energy in the residual signal, an event is detected 490. If no event is detected, then the process goes back to the start and a new window is considered. If an event is detected, as well as the event being recorded, the segment buffer is flushed 495 - the process will then continue from the start for a new window but also for a new segment. Figures 5 to 7 show a practical example of use of the method illustrated in Figure 4 for the waveform shown in Figure 1. Figure 5 shows a time-series of the parameter estimates determined through the interpolated windowed FFT. A reconstruction of the waveform from these parameters is shown in Figure 6 - as can be seen, there is little error for most of the waveform, but significant error at events which represent state transitions. If there is sufficient energy in an event, it is considered to be a state transition, and segments are defined between the state transitions, as can be seen in Figure 7.

The resulting pattern of state segments can be used in a number of different ways. Where the load is a complex appliance, the segments can be used for diagnostic purposes, as they will typically represent physical state within the appliance. The non-appearance of a particular state may indicate a component malfunction, or changes in the time before a particular state appears may indicate degradation of a component - the segments may thus be used to assist in a repair process, or to indicate that servicing is necessary. Where the load is actually an aggregate of different loads, specific states may indicate particular loads or combinations of loads being active.

The skilled person will appreciate that many further embodiments are possible within the scope of the invention as defined by the claims.

**Claims**

1. A method of detecting states of an electrical load from an electrical signal, comprising:

   providing (310) a mathematical model for the electrical signal;
   using (322) a sliding window to estimate (320) parameters of the model, wherein a plurality of windows are determined for the electrical signal, a window function is applied for each of the windows, and parameters of the model are determined (324) by interpolation;
   reconstructing (330) the waveform from the determined parameters and subtracting the reconstructed waveform from the original signal to obtain (340) a residual signal;
   determining (350) a state transition where the residual exceeds a threshold; and
   detecting (360) a state as existing for the time period between successive state transitions.

2. The method as claimed in claim 1, wherein the mathematical model is a sinusoidal model comprising a fundamental frequency and harmonics of the fundamental frequency.

3. The method as claimed in claim 1 or claim 2, wherein the window function is a Rife-Vincent window function.

4. The method of claim 3, wherein the Rife-Vincent window function is a Class 1 Rife-Vincent Window function.

5. The method of claim 4, wherein the Class 1 Rife-Vincent Window function is of order 6 or greater.

6. The method of any preceding claim, wherein the residual signal exceeding a threshold involves determining whether the root mean square value of the residual signal exceeds the threshold value.

7. The method of any preceding claim, wherein the method further comprises sampling the electrical signal into a buffer, and applying the sliding window to the buffer.

8. The method of claim 7, further comprising emptying the buffer when a state transition is detected.

9. A method of monitoring an electrical system, comprising:

   detecting states of an electrical load from an electrical signal according to the method of any of claims 1 to 8; and
   comparing the states of the electrical load with expected states of the electrical load.

10. The method of claim 9, wherein comparing the states of the electrical load with expected states of the electrical load comprises determining the presence or absence of states of the electrical load.

11. The method of claim 9 or claim 10, wherein comprising the states of the electrical load with expected states of the electrical load comprises determining times at which one or more states of the electrical load are present.

12. The method of any of claims 9 to 11, further comprising determination of a fault in the electrical system from comparing the states of the electrical load with expected states of the electrical load.

13. An electrical device comprising a detection element for detecting values of an electrical signal passing through the electrical device, wherein the detection element is adapted to carry out the method of any of claims 1 to 12.

**14.** The electrical device of claim 13, wherein the electrical device is an electrical appliance, and wherein detected states are states of the electrical appliance.

**15.** The electrical device of claim 13, wherein the electrical device is a circuit breaker.

**Patentansprüche**

**1.** Verfahren zur Erkennung von Zuständen einer elektrischen Ladung anhand eines elektrischen Signals, umfassend:

Bereitstellen (310) eines mathematischen Modells für das elektrische Signal;
Verwenden (322) eines gleitenden Fensters zur Schätzung (320) von Parametern des Modells, wobei eine Vielzahl von Fenstern für das elektrische Signal bestimmt wird, für jedes der Fenster eine Fensterfunktion angewendet wird und die Parameter des Modells durch Interpolation bestimmt werden (324);
Rekonstruieren (330) der Wellenform aus den bestimmten Parametern und Subtrahieren der rekonstruierten Wellenform vom Originalsignal, um ein Restsignal zu erhalten (340);
Bestimmen (350) eines Zustandsübergangs, bei dem der Rest einen Schwellenwert überschreitet, und
Erkennen (360) eines Zustands als für den Zeitraum zwischen aufeinanderfolgenden Zustandsübergängen vorhanden.

**2.** Verfahren nach Anspruch 1, wobei das mathematische Modell ein sinusförmiges Modell ist, das eine Grundfrequenz und Oberschwingungen der Grundfrequenz umfasst.

**3.** Verfahren nach Anspruch 1 oder Anspruch 2, wobei die Fensterfunktion eine Rife-Vincent-Fensterfunktion ist.

**4.** Verfahren nach Anspruch 3, wobei die Rife-Vincent-Fensterfunktion eine Rife-Vincent-Fensterfunktion der Klasse 1 ist.

**5.** Verfahren nach Anspruch 4, wobei die Rife-Vincent-Fensterfunktion der Klasse 1 von Ordnung 6 oder höher ist.

**6.** Verfahren nach einem der vorstehenden Ansprüche, wobei das einen Schwellenwert überschreitende Restsignal das Bestimmen umfasst, ob der quadratische Mittelwert des Restsignals den Schwellenwert überschreitet.

**7.** Verfahren nach einem der vorstehenden Ansprüche, wobei das Verfahren weiter das Abtasten des elektrischen Signals in einen Puffer und das Anwenden des gleitenden Fensters auf den Puffer umfasst.

**8.** Verfahren nach Anspruch 7, das weiter das Leeren des Puffers umfasst, wenn ein Zustandsübergang erkannt wird.

**9.** Verfahren zur Überwachung eines elektrischen Systems, umfassend:

Erkennen von Zuständen einer elektrischen Ladung anhand eines elektrischen Signals gemäß dem Verfahren nach einem der Ansprüche 1 bis 8; und
Vergleichen der Zustände der elektrischen Ladung mit erwarteten Zuständen der elektrischen Ladung.

**10.** Verfahren nach Anspruch 9, wobei das Vergleichen der Zustände der elektrischen Ladung mit erwarteten Zuständen der elektrischen Ladung das Bestimmen des Vorhandenseins oder Fehlens von Zuständen der elektrischen Ladung umfasst.

**11.** Verfahren nach Anspruch 9 oder Anspruch 10, wobei das Vergleichen der Zustände der elektrischen Ladung mit erwarteten Zuständen der elektrischen Ladung das Bestimmen von Zeitpunkten umfasst, zu denen ein oder mehrere Zustände der elektrischen Ladung vorliegen.

**12.** Verfahren nach einem der Ansprüche 9 bis 11, das weiter das Bestimmen eines Fehlers im elektrischen System durch den Vergleich der Zustände der elektrischen Ladung mit erwarteten Zuständen der elektrischen Ladung umfasst.

**13.** Elektrische Vorrichtung, die ein Erkennungselement zum Erkennen von Werten eines durch die elektrische Vorrichtung durchgehenden elektrischen Signals umfasst, wobei das Erkennungselement geeignet ist, das Verfahren nach einem der Ansprüche 1 bis 12 durchzuführen.

**14.** Elektrische Vorrichtung nach Anspruch 13, wobei die elektrische Vorrichtung ein elektrisches Gerät ist und wobei die erkannten Zustände Zustände des elektrischen Geräts sind.

**15.** Elektrische Vorrichtung nach Anspruch 13, wobei die elektrische Vorrichtung ein Leistungsschalter ist.

**Revendications**

**1.** Procédé de détection d'états d'une charge électrique à partir d'un signal électrique, comprenant :

le fait de prévoir (310) un modèle mathématique pour le signal électrique ;

l'utilisation (322) d'une fenêtre glissante pour estimer (320) les paramètres du modèle, dans lequel une pluralité de fenêtres est déterminée pour le signal électrique, une fonction de fenêtre est appliquée pour chacune des fenêtres et les paramètres du modèle sont déterminés (324) par interpolation ;

la reconstruction (330) de la forme d'onde à partir des paramètres déterminés et la soustraction de la forme d'onde reconstruite du signal original pour obtenir (340) un signal résiduel ;

la détermination (350) d'une transition d'état, dans laquelle le signal résiduel dépasse un seuil et

la détection (360) de l'existence d'un état pendant la période entre les transitions d'états successives.

2. Procédé selon la revendication 1, dans lequel le modèle mathématique est un modèle sinusoïdal comprenant une fréquence fondamentale et des harmoniques de la fréquence fondamentale.

3. Procédé selon la revendication 1 ou la revendication 2, dans lequel la fonction de fenêtre est une fonction de fenêtre de Rife-Vincent.

4. Procédé selon la revendication 3, dans lequel la fonction de fenêtre de Rife-Vincent est une fonction de fenêtre de Rife-Vincent de classe 1.

5. Procédé selon la revendication 4, dans lequel la fonction de fenêtre de Rife-Vincent de classe 1 est d'ordre 6 ou plus.

6. Procédé selon l'une quelconque des revendications précédentes, dans lequel le signal résiduel dépassant un seuil implique la détermination du fait que la valeur moyenne quadratique du signal résiduel dépasse ou non la valeur seuil.

7. Procédé selon l'une quelconque des revendications précédentes, dans lequel le procédé comprend en outre l'échantillonnage du signal électrique dans une mémoire tampon et l'application de la fenêtre glissante à la mémoire tampon.

8. Procédé selon la revendication 7, comprenant en outre le vidage de la mémoire tampon lorsqu'une transition d'état est détectée.

9. Procédé de surveillance d'un système électrique, comprenant :

la détection des états d'une charge électrique à partir d'un signal électrique selon le procédé selon l'une quelconque des revendications 1 à 8 ; et

la comparaison des états de la charge électrique avec les états attendus de la charge électrique.

10. Procédé selon la revendication 9, dans lequel la comparaison des états de la charge électrique avec les états attendus de la charge électrique comprend la détermination de la présence ou de l'absence d'états de la charge électrique.

11. Procédé selon la revendication 9 ou la revendication 10, dans lequel la comparaison des états de la charge électrique avec les états attendus de la charge électrique comprend la détermination des instants où un ou plusieurs états de la charge électrique sont présents.

12. Procédé selon l'une quelconque des revendications 9 à 11, comprenant en outre la détermination d'un défaut dans le système électrique en comparant les états de la charge électrique avec les états attendus de la charge électrique.

13. Dispositif électrique comprenant un élément de détection destiné à détecter les valeurs d'un signal électrique traversant le dispositif électrique, dans lequel l'élément de détection est adapté pour mettre en œuvre le procédé selon l'une quelconque des revendications 1 à 12.

14. Dispositif électrique selon la revendication 13, dans lequel le dispositif électrique est un appareil électrique, et dans lequel les états détectés sont des états de l'appareil électrique.

15. Dispositif électrique selon la revendication 13, dans lequel le dispositif électrique est un coupe-circuit.

Figure 1

Figure 2

```
MATHEMATICAL MODEL FOR
THE ELECTRICAL SIGNAL          310
```

```
ESTIMATE VALUES FOR PARAMETERS OF
MODEL FOR DETECTED SIGNAL                320

USE SLIDING              DETERMINE
WINDOW WITH              PARAMETERS BY
WINDOW FUNCTION          INTERPOLATION
```

322                                          324

```
RECONSTRUCT WAVEFORM
FROM PARAMETERS              330
```

```
DETERMINE RESIDUAL FROM
ORIGINAL AND RECONSTRUCTED
WAVEFORMS                    340
```

```
DETECT STATE
TRANSITIONS IN RESIDUAL      350
```

```
IDENTIFY STATES              360
```

```
ANALYSIS PROCESS
370
```

Figure 3

Current + Voltage
Waveform data
(from EMCB-1 KHz)

410

Buffer Samples
(1024 Samples EMCB)

420

Apply Rife-Vincent Window

430

Apply Fast Fourier
Transform

440

Calculate Frequency, Phase
and Amplitude of Fundamental
and Harmonics

442

Bin of largest
amplitude in
range of
nominal

444

Estimate
frequency using
interpolated
Sinc function

446

Estimate
Amplitude using
interpolated
Sinc function

448

Estimate phase
using
interpolated
Sinc function

Nominal Fundamental & harmonic frequencies
(Range of bins either side of Nominal)

450

Reconstruct Waveform

460

Subtract reconstruction
from original to get residual

470

Root-Mean Squared Error

480

> Threshold

NO

YES

490

Event Detected

Segment FIFO Buffer

495

New Segment

Figure 4

Figure 5

Figure 6

Figure 7

**EP 4 370 939 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200292608 A1

**Non-patent literature cited in the description**

- **JALEN ŠTREMFELJ** ; **DUSAN AGREZ**. Nonparametric Estimation of Power Quantities in the Frequency Domain Using Rife-Vincent Windows. *IEEE Transactions on Instrumentation and Measurement*, August 2013, vol. 62 (8), 2171-2184